# EUROPEAN PATENT SPECIFICATION

(11) **EP 3 116 289 B1**
(45) Date of publication and mention of the grant of the patent: **19.09.2018**
(21) Application number: 14884286.7
(22) Date of filing: 03.03.2014
(51) Int. Cl.: H05H 1/24, H05H 1/28, H01J 37/32, F03H 1/00, H05H 1/54

(54) **ATMOSPHERIC PRESSURE PLASMA GENERATOR AND WORK MACHINE FOR WORKPIECE**
ATMOSPHÄRENDRUCK-PLASMAGENERATOR UND BEARBEITUNGSMASCHINE FÜR WERKSTÜCK
GÉNÉRATEUR DE PLASMA À PRESSION ATMOSPHÉRIQUE ET MACHINE DE TRAITEMENT DE PIÈCES À USINER

(43) Date of publication of application: 11.01.2017
(73) Proprietor: Fuji Machine Mfg. Co., Ltd., Chiryu-shi, Aichi 472-8686 (JP)
(72) Inventor: IKEDO, Toshiyuki, Chiryu-shi Aichi 472-8686 (JP); JINDO, Takahiro, Chiryu-shi Aichi 472-8686 (JP)
(74) Representative: Grünecker Patent- und Rechtsanwälte PartG mbB
(86) International application number: PCT/JP2014/055276
(87) International publication number: WO 2015/132853

(56) References cited:
- WO-A1-2013/035375
- JP-A- S54 142 150
- JP-A- S54 142 150
- JP-A- 2010 061 938
- JP-A- 2012 178 348
- JP-A- 2012 178 348
- JP-A- 2013 152 913
- JP-A- 2013 152 913
- JP-U- S6 316 574

## Description

### Technical Field

The present invention relates to an atmospheric pressure plasma generator that generates plasma at atmospheric pressure.

### Background Art

An atmospheric pressure plasma generator, for example, plasmarizes a processing gas by applying a voltage between a pair of electrodes; the plasma is then used to perform plasma processing on a workpiece. However, when plasmarizing a processing gas, high voltage electricity is applied, causing the plasma to be a high temperature, leading to a problem of deformation or damage to the workpiece due to the heat. Taking account of the above problem, the atmospheric pressure plasma generator disclosed in the patent literature below is equipped with a gas cooling device for cooling the processing gas before applying the voltage; the processing is cooled by the gas cooling device based on the temperature of the plasma.

In detail, a temperature sensor is provided at the plasma outlet of the atmospheric pressure plasma generator and the temperature of the plasma is measured by the temperature sensor. Then, using the temperature of the plasma measured by the temperature sensor, feedback control is performed for operation of the gas cooling device. That is, operation of the gas cooling device is controlled such that, in a case in which the temperature of the plasma measured by the temperature sensor is higher than a specified temperature, the temperature of the processing gas is lowered, and, in a case in which the temperature of the plasma measured by the temperature sensor is lower than a specified temperature, the temperature of the processing gas is increased. By this, the temperature of generated plasma is maintained at a specified temperature, and high temperature plasma is prevented from being generated.

Examples of plasma generators are disclosed in Patent Literature 1, 2,3 and 4.

### Citation List

### Patent Literature

Patent Literature 1: JP-A-2010-061938
Patent Literature 2: WO 2013/035375 A1
Patent Literature 3: JP S54 142150 A
Patent Literature 4: JP 2013 152913 A

### Summary of Invention

### Technical Problem

With the atmospheric pressure plasma generator disclosed in the patent literature above, processing gas also flows around the electrodes at a temperature level around at which the processing gas is plasmarized. If plasma generation is continued at a temperature level around at which the processing gas is plasmarized, the electrodes of the atmospheric pressure plasma generator wear out quickly, thus shortening their usage life.

### Solution to Problem

To solve the above problems, the present invention provides an atmospheric pressure plasma generator according to the features of independent claim 1. Preferred embodiments are laid down in the dependent claims.

### Advantageous Effects of Invention

With the disclosed atmospheric pressure plasma generator, because the plasma generating electrode is cooled in the second region by the second processing gas, wear of the electrode is curtailed.

### Brief Description of Drawings

[Fig. 1] Fig. 1 shows an embodiment of the atmospheric pressure plasma generator.
[Fig. 2] Fig. 2 shows the embodiment of the atmospheric pressure plasma generator seen from the side of electrical discharge opening 18.

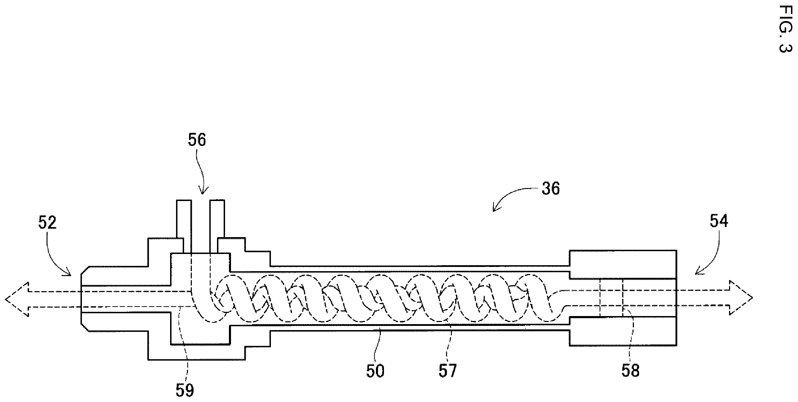

[Fig. 3] Fig. 3 shows a schematic drawing of the vortex tube provided in the atmospheric pressure plasma generator shown in fig. 1.
[Fig. 4] Fig. 4 is a block diagram showing the control device provided in the atmospheric pressure plasma generator shown in fig. 1.
[Fig. 5] Fig. 5 shows the work machine for workpiece provided with the atmospheric pressure plasma generator shown in fig. 1.

### Description of Embodiments

The following describes in detail referring to the figures an example embodiment of the present invention.

### <Configuration of the atmospheric pressure plasma generator>

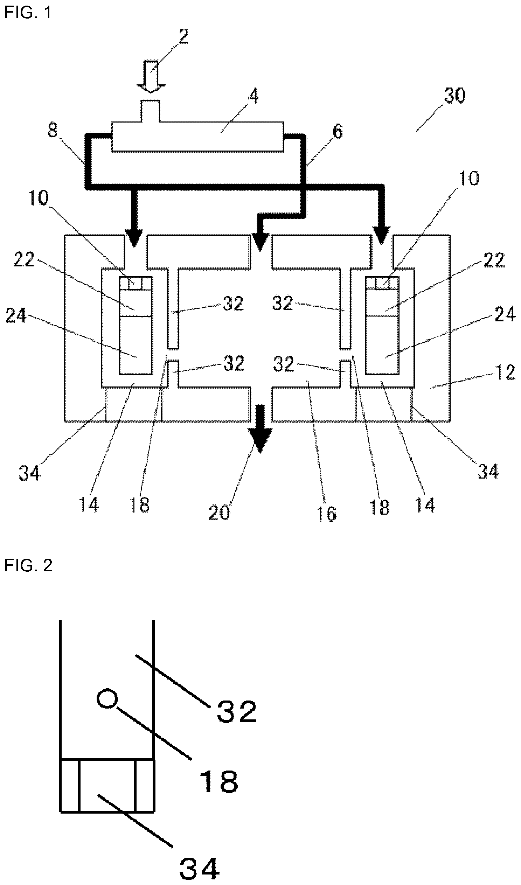

Fig. 1 shows an embodiment of the present invention, atmospheric pressure plasma generator 30. Atmospheric pressure plasma generator 30 is for generating plasma at atmospheric pressure. Atmospheric pressure plasma generator 30 includes housing 12; housing 12 is configured from first region 16 and second region 14. First processing gas flow path 6 is connected to first region 16, and outlet 20 is formed in first region 16. Outlet 20 is open in a direction facing a workpiece. An end of first processing gas flow path 6 is connected to an upper surface of first region 16: an end of second processing gas flow path 8 is connected to an upper surface of second region 14. Also, the other ends of first processing gas flow path 6 and second processing gas flow path 8 are connected to vortex tube 4 provided near housing 12.

Vortex tube 4 uses a vortex effect to generate cooling gas and heating gas. Vortex tube 4 is a well-known device, thus is described simply below. As shown in fig. 2, vortex tube 4 is provided with a substantially tube-shaped housing 50 with cool gas outlet 52 and hot gas outlet 54 formed at both ends. Further, compressed gas supply inlet 56 is formed in a side surface of tube-shaped housing 50. When compressed gas is supplied into housing 50 from compressed gas supply inlet 56, supplied gas 57 flows towards hot gas outlet 54 in a spiral along the interior walls of housing 50.

Valve 58 is provided at hot gas outlet 54. Thus, a portion of the gas supplied inside housing 50 is ejected from hot gas outlet 54 based on how much valve 58 is open/closed, and the remaining gas is returned inside housing 50. Gas 59 returned inside housing 50 by valve 58 flows inside gas 57 flowing in a spiral along the interior walls of housing 50, that is, flows along a center section of housing 50 in the diameter direction. Gas 59 flowing through the center section of housing 50 flows towards cool gas outlet 52 and is ejected from cool gas outlet 52.

When this occurs, due to the difference in the kinetic energy of gas 57 flowing in a spiral along the interior walls of housing 50 and the kinetic energy of gas 59 flowing through the center section of housing 50, heat energy is transferred from gas 59 flowing through the center section of housing 50 to gas 57 flowing in a spiral along the interior walls of housing 50. Accordingly, hot gas is ejected from hot gas outlet 54 and cooled gas is ejected from cool gas outlet 52.

As shown in fig. 1, vortex tube 4 with the configuration described above is provided near housing 12. Also, compressed gas supply inlet 56 of vortex tube 4 is connected to compressed gas flow path 2, cool gas outlet 52 is connected to second processing gas flow path 8, and hot gas outlet 54 is connected to first processing gas flow path 6.

First region 16 is separated from and sandwiched by second regions 14. Also, first region 16 is connected to vortex tube 4 such that hot gas, which is the first processing gas, flows into first region 16 via first processing gas flow path 6. Also, in first region 16, the first processing gas is plasmarized by the electrical discharge between plasma generating electrodes 24. Further, plasma flows to be ejected from outlet 20 of first region 16.

Plasma generating electrodes 24 are provided inside second regions 14 facing each other and sandwiching first region 16. Also, second regions 14 are connected to vortex tube 4 such that cool gas, which is the second processing gas, flows into second regions 14 via second processing gas flow path 8. Further, second regions 14 are separated from first region 16 by separating members 32. Further, electrical discharge opening 18 is provided in separating member 32 such that electric current flows between plasma generating electrodes 24. Cool gas, which is the second processing gas, flows into first region 16 from electrical discharge opening 18. Plasma generating electrode 24 is connected to socket 22 for wiring.

Separating members 32 are tube-shaped and as such further enable functionality. This is because the direction from the socket towards the electrode and the lengthwise direction of the tube-shaped member are approximately parallel, and because plasma generating electrode 24 is cooled efficiently by the cool gas.

Also, plasma is generated when voltage is applied to plasma generating electrodes 24, but at this time contaminants are generated at the electrode, thus causing wear. Separating member 32 is tube-shaped, and a space that stops the flow of cool gas is formed below second region by sealing member 34, thus contaminants are affixed there and are prevented from flowing into first region 16. Further, because housing 12 is compact, it is desirable that the flow direction of gas to the first region from the second region and the direction in which the cool gas flows in the second region are approximately perpendicular.

Sealing member 34 is desirably formed so as to be removable from the outside of housing 12 by a tool or the like. This facilitates performing of work to remove contaminants or exchange electrodes.

Further, a separate cool gas ejection opening may be provided in second region 14 different to electrical discharge opening 18. The enables contaminants to be collected separately, and prevents first region 16 being cooled by cool gas. Cool gas ejection opening is desirably provided in a direction not facing the workpiece, for example, in a sideways direction as shown by fig. 1.

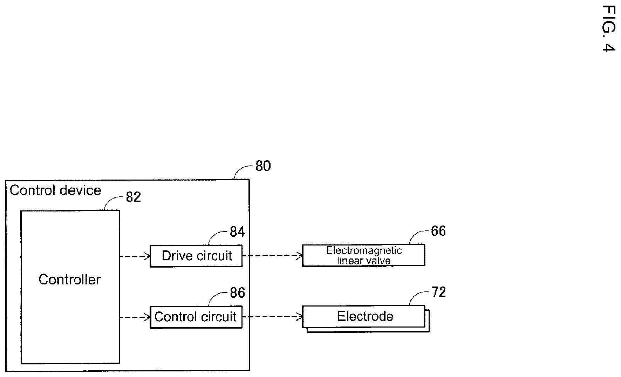

As shown in fig. 4, atmospheric pressure plasma generator 30 is provided with control device 80. Control device 80 is provided with controller 82, drive circuit 84, and control circuit 86. Drive circuit 84 is connected to electromagnetic linear valve 66. Further, this linear valve supplies compressed gas to compressed gas supply flow path 2. Also, control circuit 86 is connected to the pair of electrodes 72. Controller 182 is provided with a CPU, ROM, RAM, and so on, is formed mainly from a computer, and is connected to drive circuits 84 and control circuit 86. Thus, operation of electromagnetic linear valve 66, and applying of voltage to the pair of electrodes 72 is controlled by controller 82.

### <Generation of plasma by atmospheric pressure plasma generator>

Atmospheric pressure plasma generator 30 with the configuration described above plasmarizes gas by applying voltage to gas supplied inside housing 12. Also, atmospheric pressure plasma generator 30 performs plasma processing on a workpiece by ejecting plasma from outlet 20. The generation of plasma by atmospheric pressure plasma generator 30 is described in detail below.

First, atmospheric pressure plasma generator 30 supplies compressed processing gas to compressed gas flow path 2. Processing gas may be gas in which an inert gas such as nitrogen is mixed with active gases in the air such as oxygen at a given ratio, or may be only an inert gas, or only air. The processing gas supplied to compressed gas flow path 2 is supplied to vortex tube 4. Accordingly, as described above, processing gas is cooled and cooled processing gas is ejected from cool gas outlet 52 of vortex tube 4. Also, processing gas is heated and hot processing gas is ejected from hot gas outlet 54 of vortex tube 4.

Processing gas ejected from cool gas outlet 52 flows into second region 14 via second processing gas flow path 8. Processing gas ejected from hot gas outlet 54 flows into first region 16 via first processing gas flow path 6.

Control device 80 applies voltage to the pair of plasma generating electrodes 24 in housing 12 such that current flows between the electrodes after first region 16 and second region 14 have been filled by the first processing gas and the second processing gas respectively. Thus, an electrical discharge occurs between the electrodes, and the processing gas is plasmarized by the electrical discharge. Then, plasma is ejected from outlet 20 such that plasma processing is performed on the workpiece. Applying voltage after filling the regions with gas means that control device 80 waits for a timer, and after operation of electromagnetic linear valve 66, performs applying of voltage after a given time has elapsed, the given time being based on the known flow amount of processing gas through compressed gas flow path 2 and the volume of the space inside atmospheric pressure plasma generator 30.

Atmospheric pressure plasma generator 30 cools/heats processing gas using vortex tube 4. Therefore, atmospheric pressure plasma generator 30 cannot heat/cool processing gas in excess of the ability of vortex tube 4. Therefore, even if a problem occurs with atmospheric pressure plasma generator 30, atmospheric pressure plasma generator 30 is prevented from generating plasma at a temperature that is too cold or too hot for the workpiece.

Further, with atmospheric pressure plasma generator 30, a normally-closed type electromagnetic linear valve 66 is used. Therefore, for example, in a case in which atmospheric pressure plasma generator 30 stops supplying electric power to electromagnetic linear valve 66 for some reason, because electromagnetic linear valve 66 is a normally-closed valve, flow of processing gas into compressed gas flow path 2 is stopped. In other words, atmospheric pressure plasma generator 30 stops supplying processing gas when electric power is stopped being supplied to electromagnetic linear valve 66. In this way, atmospheric pressure plasma generator 30 reliably prevents generation of plasma that is unsuitable for the workpiece, even in a case in which electric power is stopped being supplied to electromagnetic linear valve 66.

Also, atmospheric pressure plasma generator 30 uses vortex tube 4 as an apparatus for cooling processing gas. Vortex tube 4 is able to cool processing gas without using electric power or chemicals or the like. Thus, atmospheric pressure plasma generator 30 is environmentally friendly.

Further, atmospheric pressure plasma generator 30 performs plasmarizing in the first region using hot processing gas generated by vortex tube 5. That is, atmospheric pressure plasma generator 30, in addition to not using electric power or chemicals or the like for cooling processing gas, does not use electric power or chemicals or the like when adjusting the temperature of cooled processing gas. This further increases the environmentally friendly properties of atmospheric pressure plasma generator 30.

The specifications of the vortex tube and the pressure of the compressed gas decide the temperature of the cooling gas and the heating gas. Accordingly, a fail-safe situation is achieved in which it is not possible for the temperature to be greatly larger or smaller than the design temperature.

Usually molybdenum or the like is the material used for plasma generating electrodes.

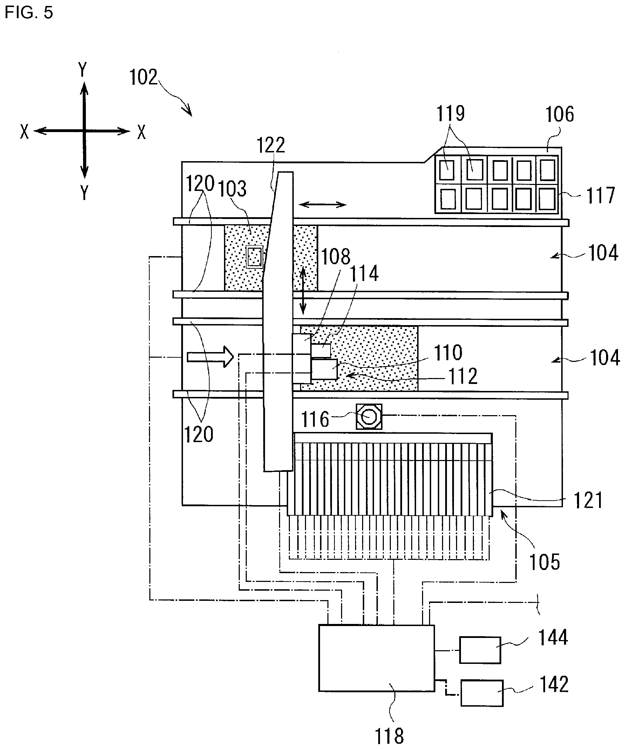

Fig. 5 shows the work machine for workpiece 102. Atmospheric pressure plasma generator 110 and vortex tube 114 are moved inside work machine for workpiece 102 by X robot 122 and Y robot 108. Workpiece 103 is loaded into and held in working machine for workpiece 102 in conveyance lane 104, and is unloaded when processing is complete.

It is desirable that the atmospheric pressure plasma generator is a work machine for workpiece including a head of a robot that moves in at least one direction, wherein the atmospheric pressure plasma generator is attached to the head, and the gas heater and the gas cooler are attached to the head. According to this configuration, the atmospheric pressure plasma generator can perform plasma processing on a workpiece efficiently. Also, the closer the vortex tube is positioned, the more efficiently cooling and heating can be performed.

Further, the present invention is not limited to the above example embodiments, and various changed or improved methods of embodiment are possible based on the knowledge of someone skilled in the art. Specifically, for example, in the above embodiments, as an apparatus for cooling processing gas, vortex tube 4 is used; however, an apparatus using a refrigeration medium or the like may be used. Also, for the adjusting the temperature of cooled processing gas, processing gas heated by vortex tube 4 is used; however, temperature adjustment of cooled processing gas may be performed by a temperature-adding device such as a heater.

The scope of the invention is defined by the claims.

### Reference Signs List

4: vortex tube; 18: electrical discharge opening; 30: atmospheric pressure plasma generator; 36: vortex tube; 80: control device; 102: working machine for workpiece

## Claims

1. An atmospheric pressure plasma generator (30) comprising:
a housing (12);
a first region (16) provided in the housing (12);
a gas heater that causes a heated first processing gas to flow into the first region (16);
a second region (14) provided in the housing (12) adjacent to the first region (16);
a gas cooler that causes a cooled second processing gas to flow into the second region (14);
a plasma generating electrode (24) provided in the second region (14);
a plasma generator that plasmarizes the first processing gas present in the first region (16) using the plasma generating electrode (24); and
an outlet (20) through which plasma gas plasmarized by the plasma generator is ejected,
a socket (22) to which the plasma generating electrode (24) is connected, and a tube-shaped separating member (32), wherein the second region (14) is separated from the first region (16) by the tube-shaped separating member (32),
the atmospheric pressure plasma generator (30) being **characterized in that** the axis from the socket (22) towards the plasma generating electrode (24) and the axis of the tube-shaped separating member (32) are approximately parallel.

2. The atmospheric pressure plasma generator (30) according to claim 1, further including two plasma generating electrodes (24) in the second region (14),
wherein
the plasma generating electrodes (24) are provided facing each other sandwiching the first region (16), an electrical discharge opening (18) is provided in the separating member (32) in a direction facing the first region (16) from the plasma generating electrodes (24), and plasma is generated by the plasma generating electrodes (24) by being passed through the electrical discharge opening (18).

3. The atmospheric pressure plasma generator (30) according to claim 1 or 2, wherein the tube-shaped separating member (32) is arranged such that the cooling direction in which the second processing gas flows and the direction of flow of the second processing gas to the first region (16) through the electrical discharge opening (18) are approximately perpendicular.

4. The atmospheric pressure plasma generator (30) according to any one of claims 1 to 3, wherein a sealing member (34) is provided at a lower end of the second region (14) such that processing gas cannot flow past, and a space is provided between a lower end of the electrical discharge opening (18) and the sealing member (34).

5. The atmospheric pressure plasma generator (30) according to any one of claims 1 to 4, wherein at least one of the gas heater and the gas cooler is a vortex tube (4).

6. The atmospheric pressure plasma generator (30) according to any one of claims 1 to 4, further including
a vortex tube (4), wherein
the gas heater is the warming outlet (54) of the vortex tube (4), and the cooler is the cooling outlet (52) of the vortex tube (4).

7. The atmospheric pressure plasma generator (30) according to claim 6, wherein the warming outlet (54) is connected to the first region (16).

8. The atmospheric pressure plasma generator (30) according to any one of claims 1 to 7, further including
a control device (80), wherein
the control device (80) is configured to apply voltage to the plasma generating electrode (24) after the first processing gas and the second processing gas have filled the housing (12).

9. A work machine for workpiece (102) comprising: a head of a robot configured to move in at least one direction, wherein
the atmospheric pressure plasma generator (30) according to any one of the claims 1 to 8 is attached to the head, and
the gas heater and the gas cooler are attached to the head.

## Patentansprüche

1. Atmosphärendruck-Plasmagenerator (30), der umfasst:
ein Gehäuse (12);
einen ersten Bereich (16), der in dem Gehäuse (12) bereitgestellt wird;
eine Gasheizung, die bewirkt, dass ein erwärmtes erstes Prozessgas in den ersten Bereich (16) strömt;
einen zweiten Bereich (14), der in dem Gehäuse (12) angrenzend an den ersten Bereich (16) bereitgestellt wird;
einen Gaskühler, der bewirkt, dass ein gekühltes zweites Prozessgas in den zweiten Bereich (14) strömt;
eine Plasmaerzeugungselektrode (24), die in dem zweiten Bereich (14) bereitgestellt wird;
einen Plasmagenerator, der das in dem ersten Bereich (16) vorhandene erste Prozessgas mittels der Plasmaerzeugungselektrode (24) plasmarisiert; und
einen Auslass (20), durch den das durch den Plasmagenerator plasmarisierte Plasmagas ausgestoßen wird,
eine Aufnahme (22), mit der die Plasmaerzeugungselektrode (24) verbunden ist, und ein rohrförmiges Trennelement (32), wobei der zweite Bereich (14) von dem ersten Bereich (16) durch das rohrförmige Trennelement (32) getrennt ist,
wobei der Atmosphärendruck-Plasmagenerator (30) **dadurch gekennzeichnet ist, dass** die Achse von der Aufnahme (22) zur Plasmaerzeugungselektrode (24) und die Achse des rohrförmigen Trennelements (32) annähernd parallel sind.

2. Atmosphärendruck-Plasmagenerator (30) nach Anspruch 1, der des Weiteren zwei Plasmaerzeugungselektroden (24) in dem zweiten Bereich (14) aufweist, wobei
die Plasmaerzeugungselektroden (24) einander zugewandt bereitgestellt werden und den ersten Bereich (16) zwischen sich anordnen, eine elektrische Entladungsöffnung (18) in dem Trennelement (32) in einer Richtung bereitgestellt wird, die dem ersten Bereich (16) von den Plasmaerzeugungselektroden (24) aus zugewandt ist, und Plasma durch die Plasmaerzeugungselektroden (24) erzeugt wird, indem es durch die elektrische Entladungsöffnung (18) geführt wird.

3. Atmosphärendruck-Plasmagenerator (30) nach Anspruch 1 oder 2, wobei das rohrförmige Trennelement (32) so angeordnet ist, dass die Kühlrichtung, in der das zweite Prozessgas strömt, und die Strömungsrichtung des zweiten Prozessgases zu dem ersten Bereich (16) durch die elektrische Entladungsöffnung annähernd rechtwinklig sind.

4. Atmosphärendruck-Plasmagenerator (30) nach einem der Ansprüche 1 bis 3, wobei ein Dichtungselement (34) an einem unteren Ende des zweiten Bereichs (14) so bereitgestellt wird, dass Prozessgas nicht vorbeiströmen kann, und ein Zwischenraum zwischen einem unteren Ende der elektrischen Entladungsöffnung (18) und dem Dichtungselement (34) bereitgestellt wird.

5. Atmosphärendruck-Plasmagenerator (30) nach einem der Ansprüche 1 bis 4, wobei wenigstens der Gasheizer oder der Gaskühler ein Wirbelrohr (4) ist.

6. Atmosphärendruck-Plasmagenerator (30) nach einem der Ansprüche 1 bis 4, der des Weiteren ein Wirbelrohr (4) umfasst, wobei
der Gasheizer der Erwärmungsauslass (54) des Wirbelrohrs (4) ist und der Kühler der Kühlungsauslass (52) des Wirbelrohrs (4) ist.

7. Atmosphärendruck-Plasmagenerator (30) nach Anspruch 6, wobei der Erwärmungsauslass (54) mit dem ersten Bereich (16) verbunden ist.

8. Atmosphärendruck-Plasmagenerator (30) nach einem der Ansprüche 1 bis 7, des Weiteren mit
einer Steuerungsvorrichtung (80), wobei
die Steuerungsvorrichtung (80) konfiguriert ist, um eine Spannung an die Plasmaerzeugungselektrode (24) anzulegen, nachdem das erste Prozessgas und das zweite Prozessgas das Gehäuse (12) gefüllt haben.

9. Arbeitsmaschine für ein Werkstück (102), die umfasst: einen Kopf eines Roboters, der konfiguriert ist, um sich in wenigstens eine Richtung zu bewegen, wobei
der Atmosphärendruck-Plasmagenerator (30) nach einem der Ansprüche 1 bis 8 an dem Kopf angebracht ist und
die Gasheizung und der Gaskühler an dem Kopf angebracht sind.

## Revendications

1. Générateur de plasma à pression atmosphérique (30) comprenant:
un logement (12);
une première zone (16) prévue dans le logement (12);
un radiateur à gaz (4) qui provoque l'écoulement d'un premier gaz de traitement chauffé dans la première zone (16);
une seconde zone (14) prévue dans le logement (12) adjacente à la première zone (16);
un refroidisseur de gaz (4) qui provoque l'écoulement d'un second gaz de traitement refroidi dans la seconde zone (14);
une électrode de génération de plasma (24) prévue dans la seconde zone (14);
un générateur de plasma qui plasmine le premier gaz de traitement présent dans la première zone (16) en utilisant l'électrode de génération de plasma (24); et
une sortie (20) à travers laquelle est éjecté le gaz plasmagène plasminisé par le générateur de plasma,
une douille (22) à laquelle est reliée l'électrode de génération de plasma (24), et un élément de séparation en forme de tube (32), dans lequel la seconde zone (14) est séparée de la première zone (16) par l'élément de séparation en forme de tube (32),
le générateur de plasma à pression atmosphérique (30) étant **caractérisé en ce que** l'axe partant de la douille (22) et allant vers l'électrode de génération de plasma (24) et l'axe de l'élément de séparation en forme de tube (32) sont sensiblement parallèles.

2. Générateur de plasma à pression atmosphérique (30) selon la revendication 1, comprenant en outre deux électrodes de génération de plasma (24) dans la seconde zone (14),
dans lequel
les électrodes de génération de plasma (24) sont disposées en regard l'une de l'autre en prenant en sandwich la première zone (16), une ouverture de décharge électrique (18) est prévue dans l'élément de séparation (32) dans une dirigée vers la première zone (16) à partir des électrodes de génération de plasma (24), et le plasma est généré par les électrodes de génération de plasma (24) en passant à travers l'ouverture de décharge (18).

3. Générateur de plasma à pression atmosphérique (30) selon les revendications 1 ou 2, dans lequel
l'élément de séparation en forme de tube (32) est agencé de sorte que la direction de refroidissement dans laquelle circule le second gaz de traitement et la direction d'écoulement du second gaz de traitement à la première zone (16) à travers l'ouverture de décharge électrique (18) sont approximativement perpendiculaires.

4. Générateur de plasma à pression atmosphérique (30) selon l'une quelconque des revendications 1 à 3, dans lequel
un élément d'étanchéité (34) est prévu à une extrémité inférieure de la seconde zone (14) de sorte que le gaz de traitement ne puisse s'écouler et un espace est ménagé entre une extrémité inférieure de l'ouverture de décharge électrique (18) et l'élément d'étanchéité (34).

5. Générateur de plasma à pression atmosphérique (30) selon l'une quelconque des revendications 1 à 4, dans lequel
au moins l'un des radiateurs à gaz (4) et le refroidisseur à gaz est un tube à vortex (4).

6. Générateur de plasma à pression atmosphérique (30) selon l'une quelconque des revendications 1 à 4, comprenant en outre un tube de Ranque-Hillsch (4), dans lequel
le radiateur à gaz (4) est la sortie de chauffage (54) du tube de Ranque-Hillsch (4), et le refroidisseur est la sortie de refroidissement (52) du tube de Ranque-Hillsch (4).

7. Générateur de plasma à pression atmosphérique (30) selon la revendication 6, dans lequel
la sortie de chauffage (54) est connectée à la première zone (16).

8. Générateur de plasma à pression atmosphérique (30) selon l'une quelconque des revendications 1 à 7, comprenant en outre un dispositif de commande 80), dans lequel
le dispositif de commande (80) est configuré pour appliquer une tension à l'électrode de génération de plasma (24) après que le premier gaz de traitement et le second gaz de traitement ont rempli le logement (12).

9. Machine d'usinage pour pièce d'usinage (102) comprenant: une tête d'un robot configurée pour se déplacer dans au moins une direction, dans lequel le générateur de plasma à pression atmosphérique (30) selon l'une quelconque des revendications 1 à 8 est fixé à la tête, et
le radiateur à gaz et le refroidisseur de gaz sont attachés à la tête.
